**Europäisches Patentamt**

(19) **European Patent Office**

**Office européen des brevets**

(11) Numéro de publication: **0 042 901**
**B1**

(12) **FASCICULE DE BREVET EUROPEEN**

(45) Date de publication du fascicule du brevet: **31.10.84**

(51) Int. Cl.³: **C 30 B 15/00,** C 30 B 15/30, C 30 B 29/06

(21) Numéro de dépôt: **80430013.5**

(22) Date de dépôt: **26.06.80**

(54) Procédé pour contrôler la teneur en oxygène des barreaux de silicium tirés selon la méthode de Czochralski.

(43) Date de publication de la demande:
**06.01.82 Bulletin 82/01**

(45) Mention de la délivrance du brevet:
**31.10.84 Bulletin 84/44**

(84) Etats contractants désignés:
**DE FR GB**

(56) Documents cités:
FR-A-2 328 509
FR-A-2 413 124

IBM TECHNICAL DISCLOSURE BULLETIN vol.
17, no. 3, aou7t 1974 New York US
H. MUELLER-KRUMBHAAR et al.: "Controlled
crystal pulling with accelerated crucible
rotation", pages 903-904

(73) Titulaire: **International Business Machines Corporation**
**Old Orchard Road**
**Armonk, N.Y. 10504 (US)**
(84) **DE GB**

(73) Titulaire: **Compagnie IBM FRANCE**
**5 Place Vendôme**
**F-75000 Paris 1er (FR)**
(84) **FR**

(72) Inventeur: **Combronde, Jacques**
**12, allée de la Chenaie**
**F-77310 - Saint Fargeau-Ponthierry (FR)**
Inventeur: **Felix, Jean-Claude**
**447 avenue de la Reine Blanche**
**F-77820 Le Chatelet en Brie (FR)**

(74) Mandataire: **Klein, Daniel Jacques Henri**
**Compagnie IBM France Département de
Propriété Industrielle**
**F-06610 La Gaude (FR)**

Courier Press, Leamington Spa, England.

EP 0 042 901 B1

# 0 042 901

## Description

### Domaine Technique

La présente invention concerne le tirage des barreaux semi-conducteurs selon la méthode de Czochralski. Elle concerne plus particulièrement un procédé de tirage de barreaux de silicium ayant une teneur (ou concentration) en atomes d'oxygène contrôlée.

### Description du problème et Etat de la Technique

Les tendances actuelles de la micro-électrique qui conduisent à des blocs semi-conducteurs, de plus en plus intégrés, exigent une connaissance des substrats utilisés, de plus en plus poussée en physique du solide. Généralement ces derniers sont en silicium monocristallin obtenu, soit par la méthode de Czochralski, soit par la méthode de zone flottante.

Il est reconnu que les barreaux de silicium tirés selon la méthode de Czochralski (appelés ci-après barreaux CZ) ont une teneur en oxygène supérieure à celle des barreaux obtenus par la méthode dite à zone flottante (appelés ci-après barreaux FZ). En outre la méthode de Czochralski permet de tirer des barreaux à fort diamètre (~15 cm).

La production de barreaux monocristallins à partir du silicium selon la méthode de Czochralski est bien connue. Dans cette méthode, un cristal germe, doté de l'orientation cristalline désirée, est amené en contact avec la surface libre d'un bain de silicium en fusion. Le bain peut aussi contenir certains dopants qui sont introduits dans le but de modifier les caractéristiques électriques du silicium. Le bain est contenu dans un creuset en silice qui est chauffé de façon à ce que le silicium en fusion soit à son point de fusion ou légèrement au-dessus. Le germe est lentement extrait du bain, dans une atmosphère inerte telle que l'argon, et le silicium se solidifie sur le germe générant un monocristal de même orientation cristalline que le germe. Ce barreau monocristallin cylindrique est obtenu en faisant tourner le germe pendant son extraction. Habituellement, la vitesse de tirage et la puissance de chauffage sont plus élevés au début, afin de provoquer un rétrécissement du monocristal. Cet étranglement a pour but d'annihiler les dislocations créés lors du choc thermique du germe trempé dans le bain. La vitesse de tirage est alors diminuée et la puissance est réduite afin de provoquer l'accroissement du diamètre du barreau à la manière d'une cône, jusqu'à ce que le diamètre désire soit atteint, cette partie est appelée "tête du barreau". La vitesse de tirage est alors maintenue constante tandis que la puissance de chauffe est légèrement augmentée de façon à compenser les pertes en calories dues à l'accroissement du cristal solide. A la fin du processus, la vitesse de tirage et la pertes en calories dues à l'accroissement du cristal solide. A la fin du processus, la vitesse de tirage et la chauffe sont de nouveau accrues, de telle sorte que le diamètre décroît pour former, à l'extrémité, une portion de cône appelée "queue du barreau".

A la température de fusion du silicium (1420°C approximativement), la surface du creuset de silice qui est en contact avec le bain en fusion se dissout et de l'oxygène sous forme atomique ou d'oxyde pénétre dans le bain, et par voie de conséquence dans le cristal de silicium.

Les barreaux CZ ont une teneur moyenne en oxygène comprise entre 15 et 45 ppma (tandis que les barreaux FZ ont une teneur moyenne comprise entre 0,01 et 0,5 ppma). Rappelons que 1 ppma signifie qu'il y a 0,5 $10^{17}$ at/cm$^3$ d'oxygène dans le silicium. Cette concentration importante en oxygène a pour le silicium des conséquences importantes, tant du point de vue électrique que du point de vue de la pureté cristalline.

En effet, en ce que concerne le premier point, les atomes d'oxygène ont tendance à diffuser lors du tirage et à se regrouper pour former des agglomérats, certains d'entre eux agissent en tant que donneurs, et peuvent donc prendre une part prépondérante dans le type de conductivité et la résistivité du silicium.

En ce qui concerne le second point, la présence de ces agglomérats dans la structure cristalline peut être source de boucles de dislocations et de défauts divers, qui peuvent nuire à la qualité cristalline du matériau et donc à la fiabilité du produit final.

Cependant dans la mesure où le phénomène est bien contrôlé il est généralement admis que la présence d'oxygène dans les substrats de silicium est généralement bénéfique. Ces agglomérats seront ultérieurement utilisés comme centres de piégeage d'impuretés non désirées au cours des différents cycles thermiques que comporte la fabrication des circuits intégrés. Ce problème particulier est décrit en détail dans la demande de brevet français FR—A—2435818 déposée le 8 septembre 1978 par la demanderesse et intitulée: "Procédé pour accroître l'effet de piégeage interne des corps semi-conducteurs".

On a découvert qu'il y avait pratiquement deux profils de concentration, selon l'équipement de tirage utilisé. Dans un premier cas, dit profil décroissant, le profil de la concentration en oxygène décroît de la tête du barreau (près du germe) à la queue. Dans un deuxième cas, dit profil en U, le profil présente un minimum de concentration au voisinage du centre du barreau.

Dans tous les cas actuellement connus, ces profils ne sont pas stables dans le temps pour un même équipement.

En outre, les niveaux d'oxygène requis doivent être adaptés aux deux grandes familles connues de produits semi-conducteurs: les bipolaires et les unipolaires pour lesquels les cycles thermiques sont

2

fondamentalement différents dans les étapes à hautes températures.

Pratiquement le problème se pose dans les termes suivants:

Dans une première application aux produits bipolaires on veut utiliser les parties de barreaux dont le niveau d'oxygène est approximativement inférieur à 35—36 ppma. Dans une autre application aux produits unipolaires on veut utiliser les parties des barreaux dont le niveau d'oxygène est approximativement supérieur à 30 ppma.

Une solution connue à ce jour est la suivante:

Selon ce procédé on découpe les tranches à partir d'un barreau CZ stabilisé à 650°C et rectifié. Ces tranches sont ensuite rodées, puis polies, et leur niveau d'oxygène mesuré par des techniques IR. Enfin elles sont triées suivant les spécifications en oxygène requises. Ce procédé peut s'avérer être coûteux, suivant la quantité de tranches rejetées.

Cependant tous les procédés de l'art antérieur ont l'inconvénient d'être des procédés "à postériori" c'est-à-dire que les barreaux sont fabriqués selon les procédés classiques mentionnés ci-dessus et les portions de barreaux sont caractérisées ensuite. Si un barreau apparaît être hors spéfication, il est rejeté. Dans tous les cas, les portions de barreau non conformes sont rejetées ce qui représente une perte importante pour les fabricants de tranches.

C'est pourquoi parallèlement la demanderesse avait déposé le 1er avril 1976 une demande de brevet français No. 70 10161 (N° de publication 2312816) et intitulée: "Procédé pour contrôler la teneur en oxygène des cristaux de silicium".

Dans cette demande on décrivait, un procédé de contrôle de teneur en oxygène de barreaux extraits d'un bain en fusion de silicium contenu dans un creuset en silice. Ce procédé comprenait le traitement du creuset afin de changer les caractéristiques superficielles de la portion du creuset qui est en contact avec le bain en fusion de façon à contrôler le contenu en oxygène du bain pendant le processus de croissance du barreau.

Dans une réalisation préférée la surface du creuset était dépolie, par un procédé tel que la sablage.

Dans une autre réalisation de l'invention la surface du creuset était soumise à un traitement thermique, tel qu'un polissage à la flamme, ou à un traitement thermique au four.

Cependant ce procédé n'a pas donné entière satisfaction. Le traitement des creusets en silice s'est révélé délicat et source de contamination (atomes de fer et/ou de cuivre). L'amélioration constatée n'était en fait significative qu'en début du tirage et par conséquent le contrôle n'était effectif que pour une faible portion en tête du barreau. Pour le reste du barreau, les opérations de caractérisation ou de tri demeuraient nécessaires.

Un autre procédé important de l'art antérieur est décrit dans le brevet français No. 76 23756 (N° de publication 2328509) déposé le 28 juillet 1976 par la demanderesse et intitulé: "Procédé pour faire croître un barreau de matériau cristallin notamment silicium avec une teneur en oxygène contrôlée". Ce procédé permet d'assurer que la concentration en oxygène dans le barreau, ne sera pas inférieure à 28 ppma. Le procédé est basé sur l'auto-nettoyage de la couche de passivation de SiO des parois du creuset et donc la réactivation du processus de dissolution de l'oxygène dans le bain de silicium en fusion. Ce procédé n'assure malheureusement pas qu'une concentration en oxygène minimum de 32 ppma soit obtenue. Cependant, ce procédé est avantageux et il peut être largement employé. Encore un autre procédé est décrit dans la référence FR—A—2413124. Dans ce brevet, pour obtenir des barreaux présentant une teneur en oxygène pratiquement constante le long du barreau, on fait croître lentement à partir d'une valeur faible (3—6 tr/mn), la vitesse de rotation du germe. La vitesse de rotation du creuset est constante. Ce procédé vise l'obtention de teneur en oxygène relativement faibles: 5—9 $10^{17}$ at/cm$^3$, soit 10—18 ppmA. En outre, la faible vitesse de rotation du barreau (10—20 tr/mm) provoque d'importants gradients de résistivité d'une part à l'intérieur d'une même tranche et d'autre part les différentes tranches d'un même barreau.

Enfin, on peut citer les travaux de H. J. Scheel publiés notamment dans l'article "Accelerated Crucible Rotation: A Novel Stirring Technique in High Temperature Solution Growth" Journal of Crystal Growth 13/14 (1972) XII.2, pages 560 à 565, qui a étudié l'effet de vitesses de rotation comportant des cycles accélération-décélération pour homogénéïser le bain. Dans cet article il n'est pas question de contrôler la teneur en oxygène, et en outre, les cycles étudiés sont très différents de ceux revendiqués dans la présente invention.

Exposé de l'Invention

Un premier objet de l'invention est de fournir un procédé de tirage de barreaux CZ qui réduit considérablement la nécessité des étapes de caractérisation et de tri de l'art antérieur, en assurant le contrôle de l'oxygène au moment du tirage et non plus au tri.

Un autre objet de l'invention est de fournir un procédé de tirage de barreaux CZ dont la concentration en oxygène peut être contrôlée selon un profil désiré de façon très précise, par exemple autour d'une valeur moyenne.

Encore un autre objet de l'invention est de fournir un procédé de tirage de barreaux CZ présentant des profils appropriés pour être utilisés directement, sur les lignes de production soit unipolaires soit bipolaires.

3

**0 042 901**

Encore un autre objet de l'invention est de fournir un procédé de tirage de barreaux CZ présentant un profil de concentration contrôlé, mettant en oeuvre un calculateur pour optimiser la vitesse de rotation du creuset.

La présente invention tire profit des études faites par la demanderesse qui ont mis en évidence la relation qui existait entre la vitesse de rotation du creuset et le profil de concentration en oxygène le long du barreau et plus particulièrement, que sa commande selon un profil particulier pouvait assurer soit un profil quelconque désiré soit un profil de concentration pratiquement constant. En effet il a été démontré qu'une faible vitesse de rotation du creuset assure une faible concentration en oxygène, tandis qu'une vitesse de rotation élevée assurait une forte concentration en oxygène dans le barreau.

La présente invention concerne donc un procédé pour contrôler la teneur en oxygène d'un barreau en cours de tirage à partir d'un bain en fusion d'un matériau semi-conducteur, typiquement du silicium, contenu dans un creuset, selon la méthode de Czochralski bien connue, ce procédé étant caractérisée en ce que la vitesse de rotation du creuset pendant le tirage est variable pendant la durée du tirage pour assurer un profil de concentration en oxygène pratiquement constant le long du barreau.

Selon l'invention la vitesse de rotation du creuset obeit à la relation grad $V_{Rc} = -K$ grad $(O_2)$, K etant un facteur de proportionalité positif La loi qui commande la variation de la vitesse de rotation du creuset $V_{Rc}$ à chaque instant du tirage, correspondant à une longueur L du barreau est la suivante: cette variation est de sens opposé à la pente de la courbe de la concentration d'oxygène $(O_2)$ qui aurait été obtenue avec une rotation fixe du creuset Ro. En d'autres termes

$$\text{signe (grad } V_{Rc}) = -\text{signe (grad } (O_2)).$$

Par exemple si le profil de concentration d'un barreau obtenu avec une rotation fixe, Ro, est linéaire, $(O_2) = a\,L + X_s$, (a étant un facteur dépendant de l'équipement et $X_s$ la concentration près du germe, tous deux étant fonction de Ro. On maintiendra $(O_2)$ constant et égal à $X_s$, par exemple, en appliquant au creuset une vitesse de rotation $V_{Rc} = -bL + Ro$, b étant un facteur fonction de a et de même signe.

Selon un mode de réalisation préféré, et pour un équipement donné on procédera aux étapes suivantes:

. établissement d'une banque de données permettant de déterminer le profil moyen de concentration en oxygène $(O_2)$ en fonction de la longueur (L), c'est-à-dire $(O_2) = f(L)$, de barreaux tirés avec une vitesse de rotation constante Ro, et

. commande de la vitesse de rotation du creuset pendant le tirage, telle que sa pente soit opposée à la pente du profil moyen de concentration, à tout moment, c'est-à-dire, grad $V_{Rc} = -k$ grad $(O_2)$, k est un facteur positif dépendant de l'équipement et du procédé qui peut être constant ou variable.

Ce procédé trouve application dans les procédés de tirage de barreaux monocristallins en silicium dont on connaît à l'avance et de façon précise la teneur en oxygène.

L'invention est exposée ci-après, plus en détail à l'aide de dessins représentant un mode de réalisation.

Brève description des figures

La figure 1 représente la concentration en oxygène $(O_2)$ en fonction de la longueur L d'un barreau tiré selon la méthode de Czochralski, et mettant en évidence un profil dit décroissant qui peut être considéré en première approximation comme étant linéaire.

La figure 2 représente la concentration en oxygène $(O_2)$ en fonction de la longueur L d'un barreau tiré selon la méthode Czochralski et mettant en évidence un profil dit en U.

La figure 3 représente la concentration en oxygène $(O_2)$ en fonction de la longueur L d'un barreau tiré selon la méthode de Czochralski avec le perfectionnement décrit dans le brevet FR—A—2328509 ci-dessus mentionné et mettant en évidence un profil dit décroissant.

La figure 4 représente le gradient de température radial entre le centre et le bord du bain de silicium en fusion pour différentes positions du creuset à l'intérieur du dispositif de chauffage, en fonction de la vitesse de rotation du creuset $V_{Rc}$.

La figure 5 représente la concentration en oxygène $(O_2)$ en fonction de la longueur L de deux barreaux tirés selon la méthode de Czochralski, à une vitesse de rotation de creuset $V_{Rc} = 8t/mn$ pour deux vitesses de montée du germe $V_{crist} = 7,5$ cm/H et 10 cm/H.

La figure 6 représente la concentration en oxygène $(O_2)$ en fonction de la longueur L de deux barreaux tirés selon la méthode de Czochralski avec le perfectionnement décrit dans la demande de brevet FR—A—2328509 à une vitesse de rotation de creuset de 25 t/mn et une vitesse de montée du germe de 7,5 cm/H.

Les figures 7A, B, C et D représentent le principe de la correction de la concentration en oxygène $(O_2)$ d'un barreau CZ quand le profil de concentration serait normalement décroissant (figures 7A & B) ou affecterait la forme d'un U (figures 7C & 7D), à vitesse de rotation de creuset $V_{Rc}$ constante.

La figure 8 représente différents profils de la concentration d'oxygène dans des barreaux CZ en fonction de la longueur L, tirés selon les différentes vitesses de rotation du creuset correspondantes représentées sur la partie inférieure de la figure.

4

La figure 9 représente différentes profils de la concentration d'oxygène en fonction de la longueur L, dans des barreaux CZ, tirés avec le perfectionnement décrit dans la demande de brevet précité FR—A—2328509, selon les différentes vitesses de rotation du creuset correspondantes représentées sur la partie inférieure de la figure.

La figure 10 représente différents profils de la concentration d'oxygène en fonction de la longueur L dans des barreaux CZ, tirés selon les différentes vitesses de rotation du creuset correspondantes représentées sur la partie inférieure de la figure.

La figure 11 représente un profil de concentration d'oxygène particulièrement plat dans un barreau CZ, tiré avec une vitesse de rotation du creuset qui a suivi le profil de vitesse représenté sur la partie inférieure de la figure.

Mode de Réalisation de l'Invention

## I. INTRODUCTION

Il a été démontré (voir demande de brevet FR—A—2460479 que l'oxygène est un paramètre essentiel de la qualité des tranches en silicium, que le minimum souhaité pour les lignes unipolaires était de 30 ppma (en fait entre 30 et 33 ppma), tandis que le maximum apparaît être aux environs de 43 ppma (pour des concentrations supérieures, les tranches montrent un taux de précipitation trop élevé). Pour les lignes bipolaires les tranches de silicium doivent avoir une concentration inférieure à environ 36 ppma, le minimum se situant entre 20 et 23 ppma.

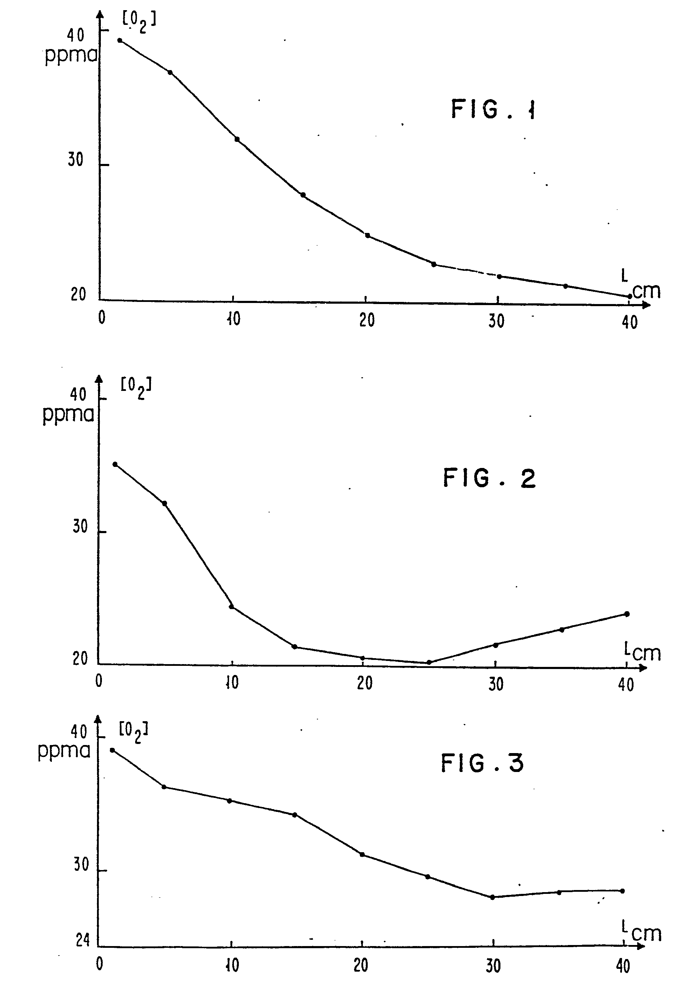

Comme il a été écrit ci-dessus, les profils de concentration en oxygène dans les barreaux CZ sont de deux types selon les équipements de tirage utilisés. Le profil dit décroissant qui est représenté sur la figure 1 et le profil en forme de U qui est représenté sur la figure 2. Ces profils ont été obtenus pour des barreaux CZ, tirés sand utiliser le procédé faisant l'objet du brevet FR—A—2328509 précité. Ces profils sont moins caractéristiques quand le procédé objet de ce brevet est utilisé. On tel profil est alors montré sur la figure 3, dans le cas du profil dit décroissant. Pour les figures 1 à 3 on a porté en abscisses la longue du barreau (en centimètre) et en ordonnées, la teneur ou concentration en oxygène (en ppma). Les mesures ont été effectuées après le tirage, sur des tranches extraites du barreau par caractérisation IR.

## II. INFLUENCE DE LA ROTATION DU CREUSET SUR LA CONCENTRATION EN OXYGENE DU BARREAU

Puisque le silicium fondu apparaît dissoudre le creuset en quartz et que ce phénomène est thermiquement activé, la teneur en oxygène devrait être reliée aux différentes paramètres qui commandent la température du creuset.

Agir directement sur la température du bain pour activer ou freiner la dissolution du creuset en quartz serait s'exposer aussitôt à la perte du contrôle du diamètre du barreau.

D'autres investigations sur la position du creuset par rapport à la résistance en graphite, sur la vitesse de montée du creuset, ont montré que les courbes de concentration en oxygène peuvent être affectées par ces paramètres, cependant, l'intervalle permis dans le procédé est trop étroit si l'on veut maintenir la structure monocristalline et éviter l'évaporation et la condensation des vapeurs de SiO au-dessus du bain.

Nous montrerons ci-après que par le biais de la rotation du creuset, nous pouvons jouer sur la température du creuset sans affecter les autres paramètres de tirage ni perdre le contrôle du diamètre du barreau.

1. Investigations préliminaires sur la vitesse de rotation du creuset ($V_{Rc}$).

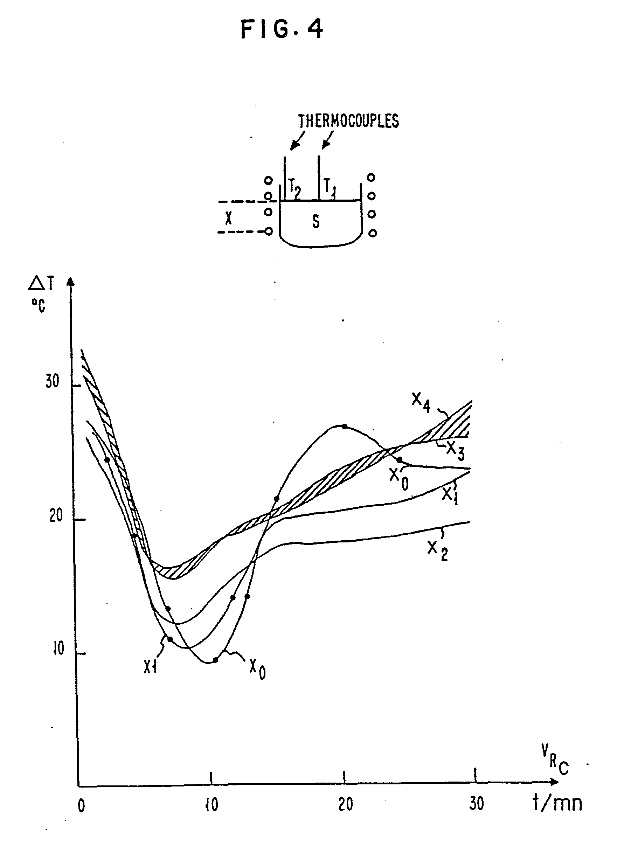

Ce paramètre qui apparaît avoir été assez peu étudié jusqu'à maintenant, a fait l'objet d'une étude détaillée. Deux thermocouples protégés par des tubes en quartz ont été disposés dans un creuset contenant 9 kilogrammes de silicium fondu, un au voisinage du centre, l'autre près de la paroi de quartz du creuset. Ils étaient connectés à un calculateur qui mesurait et enregistrait les températures toutes les 20 secondes, et ce pour toute modification apportée aux paramètres (rotation du creuset, emplacement de départ, ...). La différence de température entre la périphérie et le centre du creuset, c'est-à-dire le gradient radial $\Delta T$ en fonction de la rotation du creuset $V_{Rc}$ (en tours/mn) est montrée sur la figure 4.

On peut se rendre compte sur cette figure que le gradient $\Delta T$ peut être réduit ou augmenté selon la valeur de la vitesse de rotation du creuset. Bien que les conditions de tirage réelles soient assez différentes de ces conditions expérimentales et très dépendantes de l'équipement utilisé, on a pu extrapoler les résultats intéressants suivants: pour une hauteur arbitraire marqué "$X_0$", une rotation d'environ 10 t/mn assure un $\Delta T$ minimum. La température du creuset et la dissolution du quartz seront également minimum par voie de conséquence et la teneur en oxygène dans le barreau sera limitée, par contre une rotation de 25 t/mn aura un effet contraire.

Le paramètre X figure l'engagement du creuset dans la zone de chauffage: $X_0$ correspondant à une valeur minimum, $X_4$ correspond à une valeur moyenne, la zone hachurée est la zone de travail souhaitable. Si le paramètre X est trop faible, ou au contraire trop important, des portions du barreau seront polycristallines.

Dans la pratique les fabricants de barreaux utilisent une vitesse de rotation constant d'environ 15 t/mn, qui est donc une moyenne empirique des deux valeurs examinées ci-dessus.

Ces valeurs numériques correspondent évidemment à un certain type d'equipement, et sont susceptibles de variations.

Il est à remarquer qu'un maximum de $\Delta T$ se situe également aux faibles valeurs de la rotation du creuset. Toute la démarche sur le contrôle de l'oxygène par le biais de la rotation du creuset dont il est fait mention par la suite se trouverait inversée si l'on utilisait de faibles rotations. Ceci ne paraît cependant pas judicieux vu les risques d'inhomogénéïté du dopant dans le barreau. Il est donc important d'établir la carte thermique, c'est-à-dire la fonction $\Delta T = f(V_{Rc})$. Pratiquement, on travaille dans la partie linéairement croissante de la courbe (10 t/mn $\leq V_{Rc} \leq$ 20 t/mn) figurée par la partie hachurée dans ce cas, et ce cas seulement, la variation de vitesse a bien le signe contraire de celui du profil de concentration, résumee par le relation grad $V_{Rc} = -k$ grad ($O_2$), sinon la relation serait de la forme:

$$\text{grad } V_{Rc} = k' \text{ grad } (O_2)$$

k et k' étant deux facteurs positifs de proportionalité.

2. Effet sur la concentration d'oxygène

Pour déterminer de façon encore plus précise la relation entre la teneur en oxygène et la vitesse de rotation du creuset, deux barreaux ont été tirés avec une vitesse de rotation de 8 t/mn et deux autres avec une vitesse de 25 t/mn, tous les autres paramètres demeurant inchangés (à l'exception, dans le premier cas, de la vitesse de montée du germe où deux valeurs 7,5 cm/H et 10 cm/H ont été utilisées).

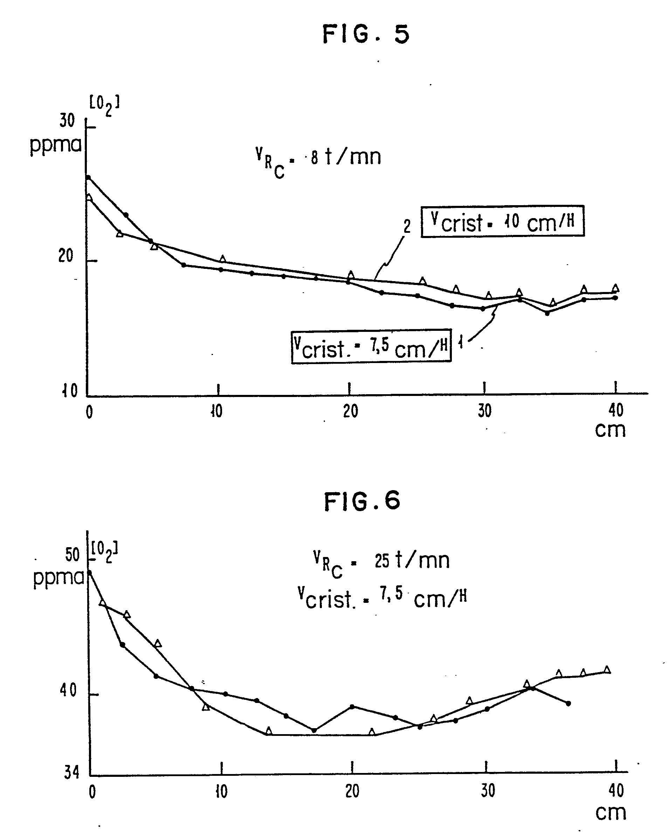

Les effets sur la teneur en oxygène sont clairement montrés sur les figures 5 et 6.

Sur la figure 5, on a représenté la teneur en oxygène (en ppma) en fonction de la longueur du barreau (en centimètre), on se rend compte que la courbe 1 met en évidence qu'avec une vitesse de montée du germe ($V_{crist.}$) de 7,5 cm/H et un $V_{Rc}$ de 8 t/mn, la teneur en oxygène varie entre 16 et 26 ppma le long du barreau (profil en U). La plus grande partie du barreau ayant une concentration en oxygène inférieure à 20 ppma. La courbe 2 ($V_{crist.}$ = 10 cm/H) montre simplement que le facteur vitesse de montée du germe n'apparaît pas être déterminant pour la concentration en oxygène du barreau CZ.

Par contre la figure 6 met en évidence qu'avec une vitesse de montée identique de celle de la courbe 1 (7,5 cm/H) mais avec une vitesse de rotation $V_{Rc}$ de 25 t/mn, la teneur d'oxygène varie entre 37 et 50 ppma le long de deux barreaux CZ qui ont été tirés lors de cette expérience.

Il faut noter que les barreaux présentant une forte teneur en oxygène peuvent poser de sévères problèmes de résistivité. Les états donneurs fournis par les atomes d'oxygène apparaissent à partir de 30 ppma si le matériau est recuit au-dessus de 600°C. Le problème devient plus aïgu au fur et à mesure que la température de traitement ou que la teneur en oxygène augmente.

3. Application au contrôle de la teneur en oxygène des barreaux CZ.

Les figures 5 et 6 ont mis en évidence le rôle important joué par la vitesse de rotation dans le profil de concentration en oxygène, la teneur en oxygène étant très dépendante de la vitesse de rotation. Ce qui est généralement souhaitable d'obtenir, c'est un profil de concentration plat ou avec de légères variations autour d'un valeur moyenne désirée.

Au lieu d'avoir une vitesse de rotation fixe pendant la durée totale du cycle, la rotation du creuset va s'effecteur selon une vitesse variable déterminée par la pente du profil de concentration en oxygène prévisible. En d'autres termes quand la concentration en oxygène diminue, la rotation du creuset sera accélérée at réciproquement. En tout état de cause les variations dans la vitesse seront suffisamment progressives pour ne pas causer de défauts (variation dans le diamètre, régions polycristallines, . . .). Un calculateur peut être utilisé pour faciliter le calcul. L'incrément maximum de vitesse retenu dans le cas des équipements de la demanderesse est de 0,1 t/mm, d'autres valeurs peuvent être évidemment utilisées selon les conditions opératoires.

Malheureusement, on ne connaît pas actuellement de procédé pour mesurer la teneur en oxygène d'un barreau en cours de tirage, la banque de données ne peut donc être constituée que quelques jours après le tirage. Les profils montrés sur les figures 5 et 6 par exemple ne sont donc disponibles que tardivement. Cependant, les profils peuvent être analysés et un profil moyen peut être déduit. Par exemple sur la figure 6, on peut se rendre compte de l'ordre de grandeur des variations entre deux barreaux tirés à quelques jours d'intervalle. Ce profil moyen approximatif peut varier dans le temps, l'analyse du profil de la vitesse de rotation devra en tenir compte. Il est à noter que si un tel procédé de mesure "on line" voyait le jour, le présent procédé de contrôle pourrait agir instantanément et corriger la teneur d'oxygène dans le sens désiré, pour obtenir un profil pratiquement plat.

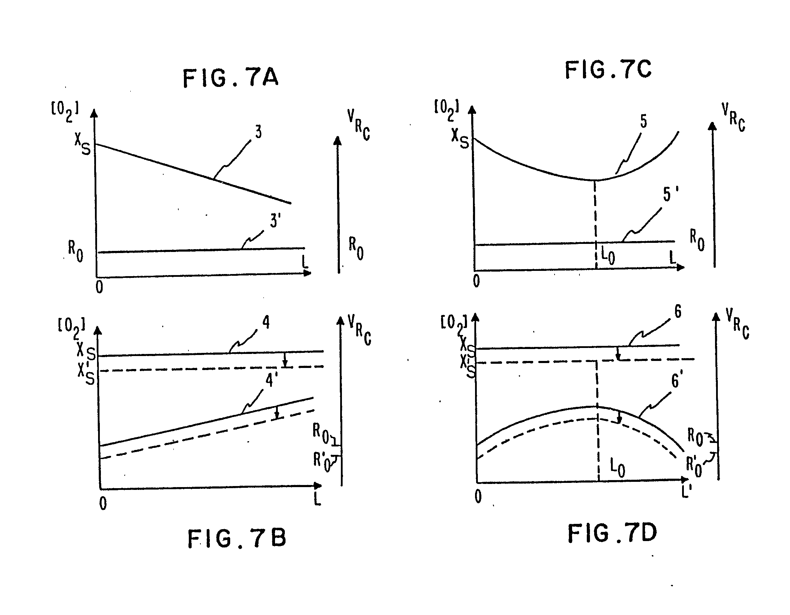

Cependant comme on l'a compris on ne rencontre jamais dans la pratique ces profils théoriques. En réalité le principe du présent procédé peut être compris schématiquement à l'aide des figures 7A à 7D. Quand l'équipement utilisé donne un profil de concentration linéaire référencé en 3 sur la figure 7A (profil dite décroissant), avec une vitesse de rotation constante (Ro) représentée en 3', un profil de concentration plat 4 sera obtenu avec une vitesse de rotation croissant linéairement dont profil est référencé en 4' (voir figure 7B). Sur cette figure l'influence de la vitesse de départ sur le niveau moyen d'oxygène est également montrée (profils en tirets).

Avec un profil de concentration dit en U (5) tel que montré sur la figure 7C obtenu lorsque la vitesse de rotation $V_{Rc}$ est constante (5'), le profil de concentration sera rendu plat (6) dès que l'on utilisera un profil de vitesse de rotation symétrique en n (6'). Ici également l'influence de la vitesse de départ est montrée par les profils en tirets de la figure 7D.

La règle mathématique à suivre est donc de respecter approximativement:

$$\mathrm{grad}\ V_{Rc} = - k\ \mathrm{grad}\ (O_2)$$

où k étant un facteur positif de proportionalité dépendant des conditions opératives qui peut être constant dans certaines applications.

4. Exemples pratiques d'application

Pour des produits destinés à une ligne unipolaire on désire des tranches dont la teneur en oxygène est comprise entre 34 et 42 ppma, c'est-à-dire présentant une valeur moyenne de 38 ppma.

Il a donc fallu empiriquement déterminer quel pouvait être le meilleur profil de la vitesse de rotation pour avoir le profil de concentration le plus plat autour de la valeur désirée.

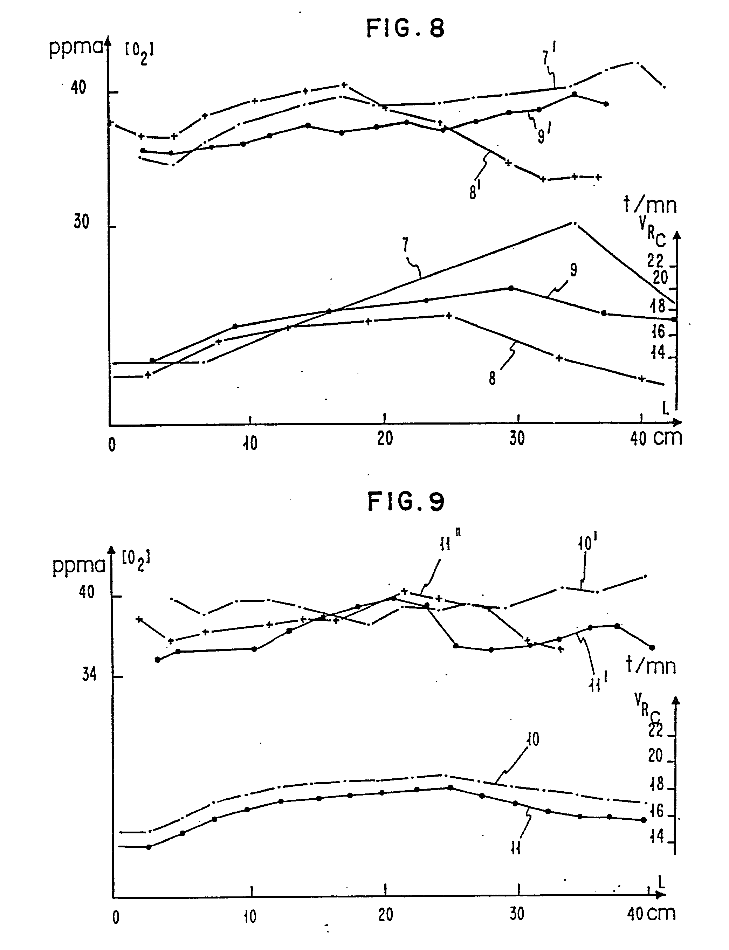

Sur la figure 8 on a montré quelques tentatives pour définir un profil de vitesse optimal. Les profils de vitesse référencés en 7, 8, 9 montrés sur la partie inférieure de la figure 8, ont respectivement fournis les profils de concentration 7', 8', 9' montrés sur la partie supérieure. On se rend compte en particulier qu'avec le profil 9, la concentration en oxygène (courbe 9') est comprise entre 35 et 40 ppma et répond donc au cahier des charges.

Sur la figure 9, où l'on recherchait un profil de concentration très serré autour de la valeur de 40 ppma, le profil de vitesse montré par la référence 10 a conduit à un barreau qui avait le profil de concentration référencé en 10', c'est-à-dire une concentration comprise entre 38 et 41 ppma.

Le problème des variations indésirables et incontrôlables mentionnés ci-dessus est mis en évidence également sur cette dernière figure. Avec un même profil de vitesse 11, deux barreaux ont été tirés, ils ont présenté les profils de concentration 11' et 11''. On remarque cependant que les concentrations sont dans les deux cas comprises entre 35 et 40 ppma, donc relativement précises, surtout si l'on compare avec les profils couramment obtenus dans l'art antérieur et qui ont été montrés sur les figures 1 à 3. On remarque également, que le profil de vitesse référencé en 11 assure bien un décalage vers des concentrations inférieures comparé au profil 10. On peut se rendre compte de l'action qui en résulte au niveau des concentrations d'oxygène en comparant la courbe 10' aux courbes 11' et 11''.

Les résultats numériques sont montrés dans la table 1 suivante.

TABLE 1

| (O$_2$) ppma barreau obtenu | MIN | MAX | TETE | MOY. | 3$\sigma$/moy. | Long. (cm) |
|---|---|---|---|---|---|---|
| Référencé 10/10' | 37,6 | 41,4 | 40 | 39,4 | 7% | 40 |
| Référencé 11/11' | 35,2 | 39,9 | 35,5 | 37,0 | 11,3% | 43 |
| Référencé 11/11'' | 35,8 | 40,2 | 38,2 | 38,1 | 10,8% | 34 |
| Procédé avec $V_{Rc}$ constante | 32 | 40 | 37 | 35 | 20% | 40 |

Le profil de vitesse référencé en 11 peut donc servir pour le tirage de barreaux destinés à une ligne unipolaire dont les spécifications seraient 33 à 43 ppma.

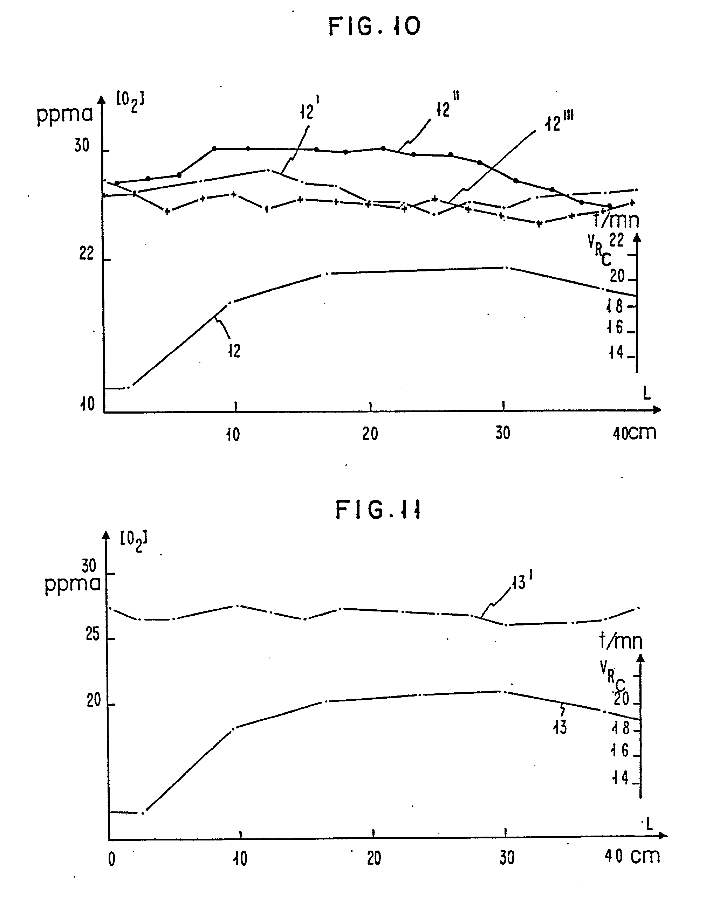

Pour des produits destinés à une bipolaire, où l'on désire des tranches dont la teneur en oxygène est comprise entre 22 et 32 ppma avec une valeur moyenne de 26 ppma, on a choisi de la même façon après diverses itérations le profil montré sur la figure 10. Avec ce profil 12, trois barreaux ont été tirés et les profils de concentration correspondant sont identifiés par les références 12', 12'' et 12'''. Les résultats sont regroupés dans la table 2.

TABLE 2

| (O₂) ppma barreau obtenu | MIN | MAX | TETE | MOY. | 3σ/moy. | Long. (cm) |
|---|---|---|---|---|---|---|
| Référencé 12/12' | 24,8 | 28,5 | 27,7 | 26,5 | 10,5% | 50 |
| Référencé 12/12'' | 24,1 | 28,6 | 26,8 | 25,8 | 11,2% | 48 |
| Référencé 12/12'' | 25,5 | 30,1 | 27,5 | 28,1 | 15% | 48 |
| Procédé avec V$_{RC}$ constante | 21 | 34 | 35 | 25 | 35% | 48 |

Ce profil apparaît donc correspondre à la production de barreaux dont les spéfications seraient de 22 à 32 ppma. La commande de la vitesse de rotation selon un profil déterminé (tel que 12) peut se faire sans difficulté, notamment grâce à l'usage d'un calculateur, qui a ce profil en mémoire.

Un profil de concentration d'oxygène particulièrement plat est montré sur la figure 11. Ce profil 13' est obtenu par la mise en oeuvre du profil de vitesse de rotation 13 et une vitesse de tirage du germe de 10 cm/H. On remarquera que la concentration en oxygène est a peu près égale à 27,5 ppma sur toute la longueur du barreau (40 cm).

En conclusion le procédé de la présente invention permet la fabrication de barreaux CZ avec des spécifications beaucoup plus précises que les procédés de l'art antérieur et permet en plus le choix dans une large gamme de la valeur moyenne de la concentration oxygène (O₂). Le présent procédé permet donc de satisfaire, à la demande, aussi bien les applications bipolaires qu'unipolaires.

Cependant, il a ses limites, la détermination du profil optimal est réalisée empiriquement et les profils de concentration différent pour chaque barreau sans que ce phénomène soit bien compris, comme on l'a montré ci-dessus.

Néanmoins le présent procédé pourra être utilisé en temps réels, pour autant que la mesure de la concentration en oxygène du barreau devienne possible.

Le présent procédé peut trouver également application pour d'autres matériaux semi-conducteurs que le silicium et de contrôler d'autres constituants que l'oxygène. Par exemple, dans la technologie des grenats GGG (gadolinium-gallium, garnet) on peut contrôler la teneur en iridium qui provient du creuset.

**Revendications**

1. Procédé pour contrôler la teneur en oxygène (O₂) d'un barreau tiré, à partir d'un bain en fusion d'un matériau semi-conducteur contenu dans un creuset en silice, selon la méthode de Czochralski caractérisé en ce que la vitesse de rotation du creuset pendant le tirage est variable pendant la durée du tirage et obeit à la relation grad V$_{RC}$ = − k grad (O₂), avec k un facteur de proportionnalité positif pour assurer une teneur en oxygène pratiquement constante le long du barreau autour d'une valeur désirée.

2. Procédé pour contrôler la teneur en oxygène d'un barreau selon la revendication 1 caractérisé en ce que ledit matériau est du silicium ou du silicium dopé par une impureté déterminant le type de conductivité désiré du barreau.

3. Procédé pour contrôler la teneur en oxygène (O₂) d'un barreau tiré, à partir d'un bain en fusion d'un matériau semi-conducteur contenu dans un creuset en silice, selon la méthode de Czochralski caractérisé en ce qu'il comporte les étapes suivantes:

établissement d'un banque de données propre à l'équipement utilisé permettant de déterminer le profil moyen de concentration en oxygène (O₂) en fonction de la longueur (L) des barreaux, c'est-à-dire (O₂) = f(L), quand lesdits barreaux sont tirés avec une vitesse de rotation du creuset V$_{RC}$ constante,

mesure du gradient de température ΔT entre le bord et le centre du bain en fonction de la vitesse de rotation du creuset V$_{RC}$,

commande de la vitesse de rotation du creuset V$_{RC}$ pendant le tirage selon un profil tel que son gradient soit opposé au gradient du profil moyen de concentration à tout moment, c'est-à-dire, qu'il obéit à la relation:

$$\text{grad } V_{RC} = - k \text{ grad } (O_2)$$

où k est un facteur positif de proportionalité, si ΔT est croissant ou

8

$$\text{grad } \dot{V}_{RC} = k' \text{ grad } (O_2)$$

où $k'$ est un facteur positif de proportionalité, si $\Delta T$ est décroissant.

4. Procédé pour contrôler la teneur en oxygène d'un barreau selon la revendication 3 caractérisé en ce que la commande de la vitesse de rotation s'effectue à l'aide d'un calculateur qui a en mémoire le profil de vitesse de rotation désiré.

5. Procédé pour contrôler la teneur en oxygène d'un barreau selon l'une des revendications 3 ou 4 caractérisé en ce que ledit matériau semi-conducteur est du silicium ou du silicium dopé par une impureté déterminant le type de conductivité désiré du barreau.

6. Procédé pour contrôler la teneur en oxygène d'un barreau de silicium tiré selon la méthode de Czochralski, caractérisé en ce que pour des applications aux lignes unipolaires, pour lesquelles spécifications des tranches sont telles que 30 ppma $\leq (O_2) \leq$ 43 ppma, le profil de la vitesse de rotation du creuset $V_{RC}$ est le suivant: plateau pendant le tirage des premiers centimètres, vitesse croissante jusqu'à environ la moitié du barreau, puis vitesse décroissante à la queue du barreau.

7. Procédé pour contrôler la teneur en oxygène d'un barreau de silicium tiré selon la méthode de Czochralski caractérisé en ce que pour des applications aux lignes bipolaires pour lesquelles les spécifications des tranches sont telles que 20 ppma $\leq O_2 \leq$ 36 ppma, le profil de la vitesse de rotation du creuset $V_{RC}$ est le suivant: plateau pendant le tirage des premiers centimètres, vitesse croissante jusqu'à environ le premier tiers du barreau, vitesse constante pendant environ le deuxième tiers du tirage du barreau et vitesse décroissante pour le troisième tiers.

## Patentansprüche

1. Verfahren für die Kontrolle des Sauerstoffgehalts ($O_2$) eines ausgezogenen Stabs, aus einem Bad eines geschmolzenen Halbleiterwerkstoffs, das sich in einem Schmelztiegel aus Silizium befindet, nach der Methode von Czochralski, dadurch gekennzeichnet, dass die Umdrehungsgeschwindigkeit des Schmelztiegels während des Ausziehens veränderlich ist und der Beziehung grad $V_{RC} = - k$ grad ($O_2$) unterliegt, mit k als positivem Verhältnisfaktor, um über die ganze Länge des Stables einen praktisch konstanten Saurestoffgehalt um einen gewünschten Wert herum zu gewährleisten.

2. Verfahren für die Kontrolle des Sauerstoffgehaltes eines Stabes gemäss Anspruch 1, dadurch gekennzeichnet, dass der genannte Werkstoff Silizium, oder mit einer Unreinheit, die den gewünschten Leitfähigkeitstyp des Stables ergibt, dotiertes Silizium ist.

3. Verfahren für die Kontrolle des Sauerstoffgehalts ($O_2$) eines ausgezogenen Stabes aus einem geschmolzenen Bad eines Halbleiters in einem Schmelztiegel aus Silizium, nach der Methode von Czochralski, dadurch gekennzeichnet, dass es folgende Schritte enthält:

Erstellung einer eigenen Datenbank für die verwendete Ausrüstung, mit der sich das durchschnittliche Profil der Sauerstoff ($O_2$)-Konzentration je nach der Länge (L) der Stäbe ermitteln lässt, das heisst ($O_2$) = f (L), wenn die genannten Stäbe mit einer konstanten Drehgeschwindigkeit $V_{RC}$ des Schmelztiegels ausgezogen werden,

Messung des Temperaturgradienten T zwischen dem Rand und der Mitte des Bades in Abhängigkeit von der Drehgeschwindigkeit $V_{RC}$ des Schmelztiegels,

Steuerung der Drehgeschwindigkeit $V_{RT}$ des Schmelztiegels während des Ausziehens nach einem Profil, das so gewählt ist, dass sein Gradient dem Gradienten des durchschnittlichen Konzentrationsprofils zu jedem Zeitpunkt entgegengesetzt ist, d.h., dass es folgende Beziehung einhält:

$$\text{grad } V_{RC} = - k \text{ grad } (O_2)$$

mit k als positivem Verhältnisfaktor, wenn T zunimmt oder

$$\text{grad } V_{RC} = k \text{ grad } (O_2)$$

mit k als positivem Verhältnisfaktor, wenn T abnimmt.

4. Verfahren für die Kontrolle des Sauerstoffgehalts eines Stabes gemäss Anspruch 3, dadurch gekennzeichnet, dass die Steuerung der Drehgeschwindigkeit mit Hilfe eines Rechners vorgenommen wird, in den das gewünschte Profil der Drehgeschwindigkeit eingespeichert wird.

5. Verfahren für die Kontrolle des Sauerstoffgehalts eines Stabes nach einem der Ansprüche 3 oder 4, dadurch gekennzeichnet, dass der genannte Halbleiterwerkstoff Silizium, oder mit einer Unreinheit, die den gewünschten Leitfähigkeitstyp des Stabes ergibt, dotiertes Silizium ist.

6. Verfahren für die Kontrolle des Sauerstoffgehalts eines ausgezogenen Siliziumstabes nach der Methode von Czochralski, dadurch gekennzeichnet, dass für Anwendungen auf einpolige Anlagen, für welche die Spezifikationen der Schnitte so sind, dass 30 ppma $\leq (O_2) \leq$ 43 ppma, das Drehgeschwindigkeitsprofil $V_{RC}$ des Schmelztiegels folgendes ist: unverändert während des Ausziehens der ersten Zentimeter, zunehmende Geschwindigkeit bis etwa zur Hälfte des Stabes, dann abnehmende Geschwindigkeit bis zum Stabende.

7. Verfahren für die Kontrolle des Sauerstoffgehalts eines ausgezogenen Siliziumstabes nach der

# 0 042 901

Methode von Czochralski, dadurch gekennzeichnet, dass für Anwendungen auf zweipolige Anlagen, für welche die Schnittspezifikationen 20 ppma $\leq O_2 \leq$ 36 ppma vorsehen, das Drehgeschwindigkeitsprofil des Schmelztiegels folgendes ist: unverändert während des Ausziehens der ersten Zentimeter, zunehmende Geschwindigkeit bis etwa zum ersten Drittel des Stabes, konstante Geschwindigkeit während ungefähr des zweiten Drittels des Stabes, un abnehmende Geschwindigkeit für das letzte Drittel.

## Claims

1. A method for controlling the oxygen concentration ($O_2$) of a rod being pulled from a semiconductor material melt contained in silica crucible according to the Czochralski Technique, characterized in that the crucible rotation speed during the pulling process is variable for the pulling duration and obeys to the following relation: grad $V_{RC} = - K$ grad ($O_2$), k being a positive proportionality factor in order to provide a practically constant oxygen concentration along the rod around a desired value.

2. Method for controlling the oxygen concentration of a rod according to claim 1 characterized in that said material consists of silicon or silicon doped with an impurity determining the type of conductivity required for the rod.

3. Method for controlling the oxygen concentration ($O_2$) of a rod being pulled from a semiconductor material melt contained in a silica crucible, according to the Czochralski Technique, characterized in that it comprises the following steps:

establishing a data bank particular to the equipment in use, to determine the average oxygen concentration profile ($O_2$) as a function of the length (L) of the rods, i.e. ($O_2$) = f(L), when said rods are pulled at a constant crucible rotation speed $V_{RC}$,

measuring the temperature gradient $\Delta T$ between the rim and the center of the melt as a function of the crucible rotation speed $V_{RC}$,

controlling the crucible rotation speed $V_{RC}$ during the pulling process according to a profile such that its gradient is opposite to the gradient of the average concentration profile at any moment, that is:

$$\text{grad } V_{RC} = - k \text{ grad } (O_2)$$

where k is a positive proportionality factor if $\Delta T$ is increasing, or

$$\text{grad } V_{RC} = k' \text{ grad } (O_2)$$

where k is a positive proportionality factor if $\Delta T$ is decreasing.

4. Method for controlling the oxygen concentration of a rod according to claim 3 characterized in that the rotation speed is controlled by using a computer which has the desired rotation speed profile in memory.

5. Method for controlling the oxygen concentration of a rod according to claim 3 or 4 characterized in that said semiconductor material consists of silicon or silicon doped with an impurity determining the type of conductivity desired for the rod.

6. Method for controlling the oxygen concentration of a silicon rod pulled according to the Czochralski Technique, characterized in that unipolar line applications whose wafer specifications are such that 30 ppma $\leqslant O_2 \leqslant$ 43 ppma, have the following crucible rotation speed profile $V_{RC}$: flat during pulling of the first centimeters, increasing speed until about half the rod is obtained, then decreasing speed at the rod tail.

7. Method for controlling the oxygen concentration of a silica rod pulled according to the Czochralski Technique characterized in that bipolar line applications whose wafer specifications are such that 20 ppma $\leqslant O_2 \leqslant$ 36 ppma, have the following crucible rotation speed profile $V_{RC}$: flat during pulling of the first centimeters, increasing speed until about one third of the rod is obtained, constant speed while pulling about the second third of the rod and decreasing speed for the third portion.

FIG . 1

FIG . 2

FIG . 3

# FIG. 4

# FIG. 5

# FIG. 6

FIG.7A

FIG.7B

FIG.7C

FIG.7D

# FIG. 8

# FIG. 9

# FIG. 10

# FIG. 11